(19) Europäisches Patentamt / European Patent Office / Office européen des brevets

(11) **EP 3 259 820 B1**

(12) **EUROPÄISCHE PATENTSCHRIFT**

(45) Veröffentlichungstag und Bekanntmachung des Hinweises auf die Patenterteilung:
**22.08.2018 Patentblatt 2018/34**

(21) Anmeldenummer: **16700886.1**

(22) Anmeldetag: **18.01.2016**

(51) Int Cl.:
*H02J 3/38* (2006.01)     *G01R 27/02* (2006.01)
*G01R 27/18* (2006.01)

(86) Internationale Anmeldenummer:
**PCT/EP2016/050889**

(87) Internationale Veröffentlichungsnummer:
**WO 2016/131584 (25.08.2016 Gazette 2016/34)**

(54) **VORRICHTUNG ZUR ISOLATIONSWIDERSTANDSBESTIMMUNG AN EINEM PV-GENERATOR UND PHOTOVOLTAIKANLAGE**

APPARATUS FOR DETERMINING INSULATION RESISTANCE AT A PV GENERATOR, AND PHOTOVOLTAIC INSTALLATION

DISPOSITIF DE DÉTERMINATION DE LA RÉSISTANCE D'ISOLATION SUR UN GÉNÉRATEUR PHOTOVOLTAÏQUE ET UNE INSTALLATION PHOTOVOLTAÏQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.02.2015 DE 102015102310**

(43) Veröffentlichungstag der Anmeldung:
**27.12.2017 Patentblatt 2017/52**

(73) Patentinhaber: **SMA Solar Technology AG 34266 Niestetal (DE)**

(72) Erfinder:
• **WILLENBERG, Mario 33102 Paderborn (DE)**
• **HERMELING, Dirk 32469 Petershagen (DE)**
• **BERGS, Volker 71034 Böblingen (DE)**
• **NESEMANN, Karl 34260 Kaufungen (DE)**

(56) Entgegenhaltungen:
EP-A1- 0 654 673     WO-A1-2014/079775
DE-A1-102011 050 590     DE-A1-102011 051 954
US-A1- 2013 121 029

EP 3 259 820 B1

## Beschreibung

Die Erfindung betrifft eine Vorrichtung zur Isolationswiderstandsbestimmung an einem Photovoltaik-Generator, an dessen Ausgangsanschluss gleichzeitig eine Einrichtung zur Anhebung des elektrischen Potenzials gegenüber Erde angeschlossen ist, sowie eine Photovoltaikanlage mit einer solchen Vorrichtung. In der Regel sind Photovoltaik-Generatoren an Photovoltaik-Wechselrichter angeschlossen, die den vom Photovoltaik-Generator (kurz PV-Generator) erzeugten Gleichstrom in einen netzkonformen Wechselstrom wandeln. Daher ist es besonders vorteilhaft, eine erfindungsgemäße Vorrichtung zur Isolationswiderstandsbestimmung in den angeschlossenen Photovoltaik-Wechselrichter zu integrieren.

Vorrichtungen zur Isolationswiderstandsbestimmung sind aus Sicherheitsgründen vorgeschrieben und werden oft eingangsseitig eines Photovoltaik-Wechselrichters integriert, um die Isolationsüberwachung des dort angeschlossenen PV-Generators zu gewährleisten. Vorrichtungen zur Isolationswiderstandsbestimmung sind beispielsweise aus der EP 0 654 673 B1 bekannt, gemäß welcher durch das Anlegen mehrerer Impulswechselspannungen an das zu überwachende Netz für jeden Impulsspannungswert der Messspannung der zeitliche Verlauf des Einschwingvorgangs des Messstroms bis zum Erreichen eines Einschwingzustands überwacht wird und die Messwertdifferenz zweier aufeinanderfolgender Messwerte zur Bestimmung des Isolationswiderstands zwischen Netz und Erde benutzt wird.

Sind an den Photovoltaik-Wechselrichter Photovoltaik-Module angeschlossen, die für Degradationseffekte anfällig sind, beispielsweise PID (potential induced degradation) bei kristallinen Modulen oder TCO-Korrosion (transparent conductive oxide corrosion) bei Dünnschichtmodulen, so werden zur Vermeidung dieser Effekte Einrichtungen zur Anhebung des elektrischen Potenzials gegenüber Erde angeschlossen. Solche Einrichtungen sind hinlänglich bekannt, als Beispiel sei die DE 20 2006 008 936 U1 der Anmelderin benannt. Diese Methode wird besonders bei Photovoltaik-Großanlagen mit ungeerdetem PV-Generator und galvanischer Trennung zum geerdeten AC-Netz eingesetzt. Die Einrichtung zur Anhebung des elektrischen Potenzials gegenüber Erde kann dabei den Minuspol oder den Pluspol des PV-Generators auf ein definiertes Potenzial gegenüber Erde versetzen, wobei man typischerweise den PV-Generator so anhebt, dass der gesamte PV-Generator (inklusive seines Minuspols) positiv gegenüber Erdpotenzial liegt. Im Rahmen der hier vorgelegten Erfindung soll mit dem Begriff "anheben" keinerlei Richtungsangabe des Potenzialbezugs impliziert sein, gemeint ist hier lediglich, dass mit der Einrichtung zur Anhebung des elektrischen Potenzials gegenüber Erde ein festes, definiertes Bezugspotenzial, meist mittels einer Spannungsquelle, vorgegeben wird.

In DE 10 2011 051 954 A1 wird eine Vorrichtung für eine Photovoltaikanlage mit einer Vorspannungserzeugungseinrichtung zur Erzeugung einer Vorspannung an einem Wechselrichter der Photovoltaikanlage beschrieben, die TCO-Korrosionen und Polarisationseffekte vermeiden soll. Die DE 10 2011 055 220 A1 bezieht sich auf ein Verfahren zum Zuschalten eines transformatorlosen Wechselrichters in einem Solarkraftwerk mit verschobenem Potentialmittelpunkt.

Wenn nun eine Einrichtung zur Anhebung des elektrischen Potenzials gegenüber Erde an einem PV-Generator gleichzeitig parallel mit einer Vorrichtung zur Isolationswiderstandsbestimmung mittels eines aktiven Verfahrens, wie oben beschrieben, an einem PV-Generator betrieben wird, treten Probleme auf. Die Einrichtung zur Anhebung des elektrischen Potenzials gegenüber Erde hält das Potenzial des PV-Generators gegenüber Erde fest, während die Vorrichtung zur Isolationswiderstandsbestimmung versucht, das Potenzial des PV-Generators gegenüber Erde zu verschieben. Da meist die Einrichtungen zur Anhebung des elektrischen Potenzials eine höhere Leistungsfähigkeit besitzen als die Vorrichtung zur Isolationswiderstandsbestimmung, wird die Vorrichtung zur Isolationswiderstandsbestimmung "überstimmt" und es wird ein zu kleiner, zumindest aber ein verfälschter Isolationswiderstandswert gemessen.

Aus diesem Grund wird in der Praxis die Einrichtung zur Anhebung des elektrischen Potenzials gegenüber Erde an einem PV-Generator zeitweise abgeschaltet, um mittels der Vorrichtung zur Isolationswiderstandsbestimmung an einem PV-Generator dessen Isolationswiderstand zu bestimmen. Dies bedeutet, dass die Isolationswiderstandsbestimmung nicht kontinuierlich, sondern nur zu bestimmten Zeitpunkten durchgeführt wird. Dieser Zustand ist unbefriedigend, da einerseits der PV-Generator zur Vermeidung von Degradationseffekten dauerhaft auf dem von der Einrichtung zur Anhebung des elektrischen Potenzials gegenüber Erde vorgegebenen Potenzial liegen soll, aber auch die Isolationswiderstandsbestimmung aus Sicherheitsgründen jederzeit möglich sein sollte.

Daher besteht Bedarf an einer Vorrichtung zur Isolationswiderstandsbestimmung an einem PV-Generator, die dauerhaft und gleichzeitig mit der Anhebung des elektrischen Potenzials gegenüber Erde funktioniert und eine genaue Angabe des Isolationswiderstandes des PV-Generators erlaubt.

Diese Aufgabe wird gelöst durch eine Vorrichtung nach Anspruch 1, sowie durch eine Photovoltaikanlage gemäß Anspruch 7. Bevorzugte Ausführungsformen sind in den abhängigen Ansprüchen beschrieben.

Eine erfindungsgemäße Vorrichtung zur Isolationswiderstandsbestimmung an einem PV-Generator umfasst eine erste Einheit zur dauerhaften Anhebung des Generatorpotenzials an einem Ausgangsanschluss des PV-Generators und eine zweiten Einheit zur Isolationswiderstandsbestimmung. Die zweite Einheit zur Isolationswiderstandsbestimmung schaltet eine Messspannung an den Ausgangsanschluss des PV-Generators und misst einen ersten Stromwert und einen ersten Spannungswert vor der Zuschaltung der Messspannung und einen zweiten Stromwert und einen zweiten Spannungswert nach der Zuschaltung der Messspannung. Der Isolationswiderstand des PV-Generators wird unter Berücksichtigung der gemessenen Strom- und Spannungswerte bestimmt. Die erste und zweite Einheit der erfindungsgemäßen Vorrichtung sind in Reihe geschaltet. Die Reihenfolge der Reihenschaltung ist hierbei unerheblich.

In einer vorteilhaften Ausgestaltung der erfindungsgemäßen Vorrichtung sind die erste und zweite Einheit als separate Geräte betreibbar. Hierdurch kann ein bereits bestehendes System zur Potentialanhebung durch ein System zur Isolationsüberwachung erweitert werden oder umgekehrt kann ein System zur Isolationsüberwachung durch ein System zur Potentialanhebung ergänzt werden.

In einer weiteren vorteilhaften Ausgestaltung der erfindungsgemäßen Vorrichtung sind die erste und zweite Einheit in einem Gerät integriert, vorzugsweise sind die erste und zweite Einheit in einen Photovoltaik-Wechselrichter integriert.

In einer weiteren vorteilhaften Ausgestaltung der erfindungsgemäßen Vorrichtung werden ein dritter Stromwert und ein dritter Spannungswert, insbesondere nach Ausschaltung der Messspannung, gemessen. Besonders vorteilhaft werden der dritte Strom- und Spannungswert zur Beurteilung von Parametern herangezogen, die Isolationswiderstandsbestimmung beeinflussen. Insbesondere sollen Parameter beurteilt werden, die während des Gesamtzeitraumes der Messungen der ersten bis dritten Strom- und Spannungswerte variieren können, und die die Bestimmung des Isolationswiderstands beeinflussen können.

Eine erfindungsgemäße Photovoltaikanlage weist einen PV-Generator auf, der über Anschlüsse mit einem Photovoltaik-Wechselrichter verbunden ist, wobei eine vorbeschriebene Vorrichtung zur Isolationswiderstandsbestimmung mit einem der Anschlüsse verbunden ist.

Im Folgenden wird die Erfindung anhand mehrerer Ausführungsbeispiele mit Hilfe von Figuren näher erläutert, wobei

Figur 1    eine schematische Darstellung eines Systems aus Photovoltaikgenerator, Wechselrichter und erfindungsgemäßer Vorrichtung,

Figur 2    eine schematische Darstellung von Messwertverläufen, sowie

Figur 3    eine schematische Darstellung eines Systems aus Photovoltaikgenerator, Wechselrichter und erfindungsgemäßer Vorrichtung mit zusätzlicher Spannungsmessung zeigt.

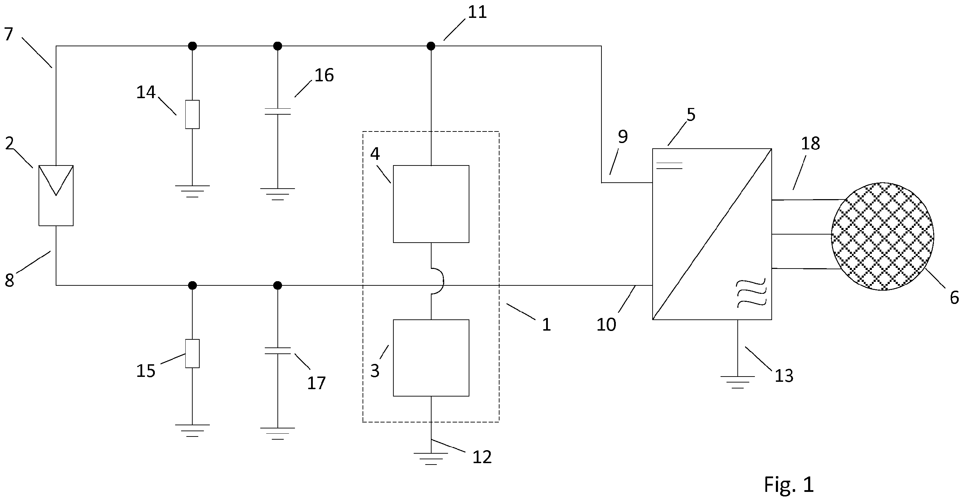

Figur 1 zeigt als Ausführungsbeispiel eine Photovoltaikanlage 20 mit einem PV-Generator 2 der mit seinen Anschlüssen 7 und 8 mit den Eingangsanschlüssen 9, 10 eines Photovoltaik-Wechselrichters 5 verbunden ist. An eines dieser Anschlusspaare ist eine erfindungsgemäße Vorrichtung 1 zur Isolationswiderstandsbestimmung mit einem Anschluss 11 angeschlossen. Ein weiterer Anschluss 12 ist an Erde angeschlossen. Der Photovoltaik-Wechselrichter 5 ist mit seinen Ausgangsanschlüssen 18 an ein Netz 6 angeschlossen, hierbei kann es sich um ein größeres Verbundnetz oder auch ein Inselnetz handeln. Der Photovoltaik-Wechselrichter 5 kann auch lokale DC- oder AC-Lasten (nicht gezeigt) versorgen oder Energie in das Netz 6 einspeisen.

Die Vorrichtung 1 zur Isolationswiderstandsbestimmung umfasst eine erste Einheit 3 und eine zweite Einheit 4. Zum Schutz vor Degradationseffekten dient die erste Einheit 3, die in diesem Beispiel den Pluspol des PV-Generators 2 um einen Spannungswert von 700 bis 1000 V gegenüber Erde anhebt, hier im folgenden Offset-Spannung genannt. Die erste Einheit 3 kann aus einer Spannungsquelle bestehen, die einen im normalen Betrieb auftretenden Leckstrom des PV-Generators nach Erde kompensieren kann, üblicherweise ist dieser auf ein ungefährliches Maß z.B. 30 bis 100 mA beschränkt. Die Spannungsquelle kann eine entsprechende Strombegrenzung enthalten. Falls das an den Photovoltaik-Wechselrichter 5 angeschlossene Netz einen festen Erdbezug hat, muss entweder der Photovoltaik-Wechselrichter 5 potenzial-trennend ausgeführt sein oder es kann zwischen Photovoltaik-Wechselrichter 5 und Netz 6 ein Transformator zwischengeschaltet sein, damit die Potenzialanhebung wirken kann.

Die zweite Einheit 4 dient zur Bestimmung des Isolationswiderstandes des PV-Generators 2, der in der Figur durch die Widerstände 14 und 15 veranschaulicht wird. Im realen PV-Generator sind eine Vielzahl an verteilten Ableitwiderständen gegen Erde vorhanden, die den einzelnen Komponenten des PV-Generators 2 (PV-Module, PV-Kabel, ...) zugeordnet werden können. Als Ersatzschaltbild können diese Ableitwiderstände äquivalent durch einen ersten Widerstand 14 vom positiven Pol des PV-Generators 2 gegen Erde und in einem zweiten Widerstand 15 vom negativen Pol des PV-Generators 2 gegen Erde dargestellt werden. Beide Widerstände können unterschiedlich groß sein. Der Isolationswiderstand des PV-Generators 2 entspricht der Parallelschaltung beider in Figur 1 dargestellten Widerstände. Die zweite Einheit 4 wendet ein aktives Verfahren zu Bestimmung des Isolationswiderstandes an, wie es z.B. in der EP 0 654 673 B1 beschrieben wird. Dazu wird der von der ersten Einheit 3 generierten Offset-Spannung eine weitere Spannung sprunghaft angelegt und der Verlauf der Spannung U an Anschluss 11 gegen Erde und der Strom I durch die Einheiten 3 und 4 gemessen.

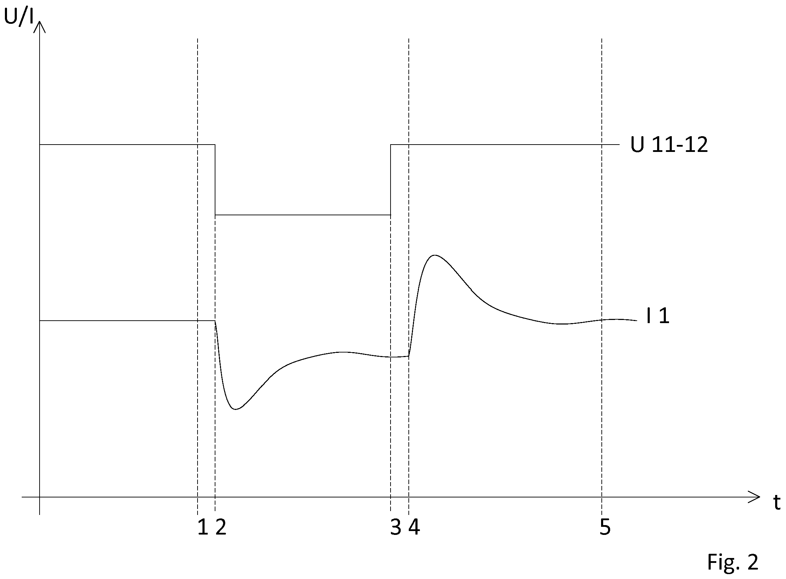

Figur 2 zeigt beispielhaft wie die zeitlichen Stromverläufe I bzw. Spannungsverläufe U aussehen können, wenn ein Verfahren wie oben beschrieben zur Anwendung kommt. Zum Zeitpunkt $t_1$ werden Strom- und

Spannung ($I_1$, $U_1$) an bzw. durch die zweite Einheit 4 gemessen. Zum Zeitpunkt $t_2$ wird eine Messspannung zugeschaltet, die sich zu der Offset-Spannung von der ersten Einheit 3 addiert. Da PV-Generatoren durch ihre flächige Ausdehnung auch als Kapazitäten wirken, in Figur 1 durch die Kondensatoren 16, 17 symbolisiert, wird der Stromverlauf nach Zuschaltung der Messspannung durch Überschwinger und ein langsames Abklingen bis zum neuen Ruhezustand charakterisiert. Nach der Abklingphase zum Zeitpunkt $t_3$ werden wieder Strom und Spannung ($I_3$, $U_3$) gemessen. Zum Zeitpunkt $t_4$ wird die Messspannung wieder ausgeschaltet, nun liegt wieder die ursprüngliche Offset-Spannung an Anschluss 11 an.

Zur Bestimmung des Isolationswiderstandes $R_{iso}$ des PV-Generators 2 wird das Verhältnis von Spannungsänderung zu der Stromänderung der ermittelten Messwerte ausgewertet:

$$R_{iso} = \frac{U_1 - U_3}{I_1 - I_3}$$

Dieser Zusammenhang ist nur gültig unter der Voraussetzung, dass sich beispielsweise die Spannung am PV-Generator 2 über den Anschlüssen 7 und 8 zwischen den Zeitpunkten $t_1$ bis $t_3$ nicht ändern. Zusätzlich muss auch der Isolationswiderstand $R_{iso}$ selbst während der zwischen den beiden Messzeitpunkten konstant bleiben. Um zu beurteilen, ob die ermittelten Messwerte zur genauen Bestimmung des Isolationswiderstandes $R_{iso}$ geeignet sind, wird zum Zeitpunkt $t_5$ ein weiteres Messwertepaar ($I_5$, $U_5$) ermittelt, wiederum nach Abwarten einer "Einschwingzeit". Ist dann $U_1$ gleich $U_5$ und $I_1$ gleich $I_5$ kann man davon ausgehen, dass sich während der Gesamtdauer der Messungen die relevanten Bedingungen nicht geändert haben und aus obiger Formel mit hinreichender Genauigkeit auf den des Isolationswiderstand $R_{iso}$ geschlossen werden kann.

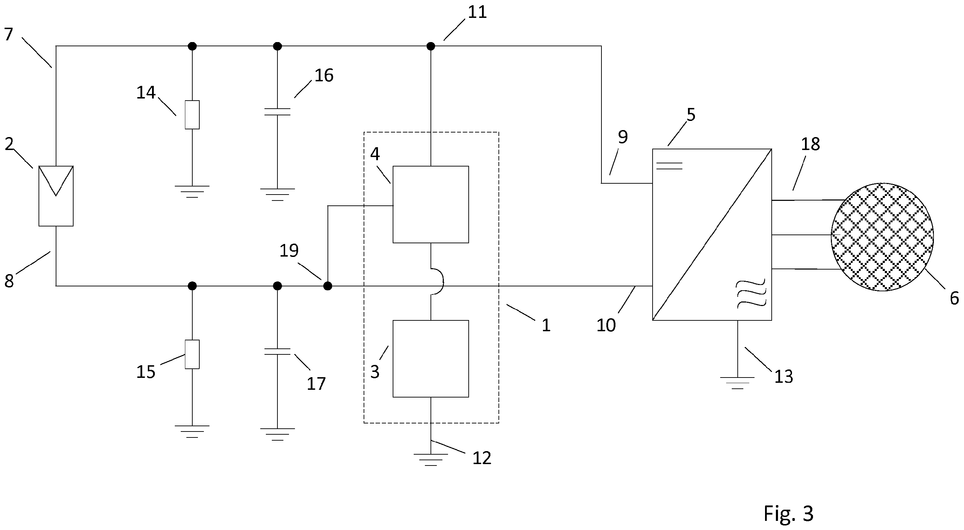

Da es möglich ist, dass sich die Spannung am PV-Generator 2 ändert (z.B. durch Einstrahlungsänderungen oder durch das MPP-Tracking des PV-Wechselrichters 5), ist es vorteilhaft, den Fehlereinfluss dieser Spannung auszuschließen. In Figur 3 ist eine vorteilhafte Ausgestaltung der erfindungsgemäßen Vorrichtung dargestellt, die dieses Ziel erreicht. Die zweite Einheit 4 misst dabei zusätzlich zur Spannung zwischen dem Anschluss 11 gegen Erde (nachfolgend $U_p$ genannt) auch die Spannung zwischen Anschluss 19 gegen Erde (nachfolgend $U_n$ genannt). Der Isolationswiderstand lässt sich dann folgendermaßen berechnen:

$$R_{iso} = \frac{U_p + k \times U_n}{I \times (k + 1)}$$

Der Faktor k steht hierbei für das Verhältnis der Widerstandswerte $R_{14}$, $R_{15}$ der Widerstände 14 und 15 zueinander.

$$k = \frac{R\_14}{R\_15}$$

Wie in der Berechnungsformel des Isolationswiderstandes $R_{iso}$ zu sehen ist, kann der Wert direkt aus den momentanen Messwerten $U_p$, $U_n$ und I berechnet werden, sofern ein Wert für k bekannt ist.

Der Faktor k lässt sich durch ein aktives Verfahren bestimmen, indem zu der von der ersten Einheit 3 generierten Offset-Spannung eine weitere von der zweiten Einheit 4 erzeugte Spannung sprunghaft angelegt und die Spannungsverläufe der Spannungen $U_p$ und $U_n$ sowie der Strom durch die Einheiten 3 und 4 gemessen wird. Man erhält damit in ähnlicher Weise wie in Figur 2 gezeigt Messwertpaare ($U_{p1}$, $U_{n1}$, $I_1$) für Zeitpunkt $t_1$ sowie ($U_{p3}$, $U_{n3}$, $I_3$) für Zeitpunkt $t_3$. Damit kann der Faktor k wie folgt bestimmt werden:

$$k = \frac{I_3 \times U_{p1} - I_1 \times U_{p3}}{I_1 \times U_{n3} - I_3 \times U_{n1}}$$

Der Parameter, der sich während Messzeitpunkte nicht ändern darf, ist der Isolationswiderstand $R_{iso}$ selbst. Um diesen Fehlereinfluss überprüfen zu können, kann in gleicher Weise wie in Figur 2 gezeigt ein dritter Messzeitpunkt $t_5$ hinzugezogen werden. Wenn die berechneten Isolationswiderstandswerte zum Messzeitpunkt $t_1$ und $t_5$ übereinstimmen, kann mit hinreichender Genauigkeit auf den des Isolationswiderstandes $R_{iso}$ geschlossen werden.

**Bezugszeichenliste**

| | |
|---|---|
| 1 | Vorrichtung zur Isolationswiderstandsbestimmung |
| 2 | PV-Generator |
| 3 | erste Einheit |
| 4 | zweite Einheit |
| 5 | Photovoltaik-Wechselrichter |
| 6 | Netz |
| 7,8 | Anschluss |
| 9, 10 | Eingangsanschluss |
| 11 | Anschluss |
| 12 | Anschluss an Erde |
| 13 | Anschluss an Erde |
| 14, 15 | Ableitwiderstand |
| 16, 17 | Ableitkondensator |
| 18 | Ausgangsanschluss |
| 19 | Anschluss |
| 20 | Photovoltaikanlage |

**Patentansprüche**

1. Vorrichtung (1) zur Isolationswiderstandsbestimmung an einem PV-Generator (2) umfassend:

   - eine erste Einheit (3) zur dauerhaften Anhebung des Generatorpotentials an einem Ausgangsanschluss des PV-Generators (2)
   - eine zweiten Einheit (4) zur Isolationswiderstandsbestimmung, eingerichtet dazu, durch

     ∘ Zuschaltung einer Messspannung an dem Ausgangsanschluss des PV-Generators (2) und
     ∘ Messen von einem ersten Stromwert und einem ersten Spannungswert vor der Zuschaltung der Messspannung und
     ∘ Messen von einem zweiten Stromwert und einem zweiten Spannungswert nach der Zuschaltung der Messspannung

   den Isolationswiderstand des PV-Generators(2) unter Berücksichtigung der gemessenen Strom- und Spannungswerte zu bestimmen,

   **dadurch gekennzeichnet, dass**

   - die erste und zweite Einheit (3, 4) in Reihe geschaltet sind.

2. Vorrichtung nach Anspruch 1, **dadurch gekennzeichnet, dass** die erste und zweite Einheit (3, 4) als separate Geräte vorgesehen sind.

3. Vorrichtung nach Anspruch 1, **dadurch gekennzeichnet, dass** die erste und zweite Einheit (3, 4) in einem Gerät integriert sind.

4. Vorrichtung nach einem der vorangehenden Ansprüche, **dadurch gekennzeichnet, dass** die zweite Einheit (4) dazu eingerichtet ist, weiterhin einen dritten Stromwert und ein dritten Spannungswert nach Ausschaltung der Messspannung zu messen und bei der Bestimmung des Isolationswiderstandes zu berücksichtigen.

5. Vorrichtung nach Anspruch 4, **dadurch gekennzeichnet, dass** die zweite Einheit (4) dazu eingerichtet ist, den dritten Stromwert und den dritten Spannungswert zusätzlich zur Beurteilung einer Variation von die Isolationswiderstandsbestimmung beeinflussenden Parametern während des Gesamtzeitraumes der Messungen zu verwenden.

6. Vorrichtung nach Anspruch 3, **dadurch gekenn-**

zeichnet, dass
die erste und zweite Einheit (3, 4) in einen Photovoltaik-Wechselrichter (5) integriert sind.

7. Photovoltaikanlage (20) umfassend einen PV-Generator (2), der über Anschlüsse (7,8) mit einem Photovoltaik-Wechselrichter (5) verbunden ist, wobei eine Vorrichtung (1) zur Isolationswiderstandsbestimmung nach einem der Ansprüche 1 bis 6 mit einem der Anschlüsse (7, 8) verbunden ist.

**Claims**

1. An apparatus (1) for determining insulation resistance at a PV generator (2) comprising:

   - a first unit (3) for permanently lifting the generator potential at an output terminal of the PV generator (2),
   - a second unit (4) for determining insulation resistance, which is configured, by way of

     ∘ connecting a measurement voltage to the output terminal of the PV generator (2) and
     ∘ measuring a first current value and a first voltage value before the measurement voltage is connected and
     ∘ measuring a second current value and a second voltage value after the measurement voltage is connected,

   to determine the insulation resistance of the PV generator (2) taking into account the measured current and voltage values,

   **characterized in that**

   - the first and second unit (3, 4) are connected in series.

2. The apparatus as claimed in claim 1, **characterized in that** the first and second unit (3, 4) are provided as separate devices.

3. The apparatus as claimed in claim 1, **characterized in that** the first and second unit (3, 4) are integrated in one device.

4. The apparatus as claimed in one of the preceding claims, **characterized in that** the second unit (4) is furthermore configured to measure a third current value and a third voltage value after the measurement voltage has been switched off and to take said values into account when determining the insulation resistance.

5. The apparatus as claimed in claim 4, **characterized**

**in that** the second unit (4) is configured to use the third current value and the third voltage value additionally to an assessment of a variation of parameters that influence the insulation resistance determination during the whole measurement period.

6. The apparatus as claimed in claim 3, **characterized in that** the first and second unit (3, 4) are integrated into a photovoltaic inverter (5).

7. A photovoltaic installation (20), comprising a PV generator (2), which is connected to a photovoltaic inverter (5) by means of terminals (7, 8), wherein an apparatus (1) for determining insulation resistance as claimed in one of claims 1 to 6 is connected to one of the terminals (7, 8).

**Revendications**

1. Dispositif (1) pour la détermination de la résistance d'isolation au niveau d'un générateur PV (2) comprenant :

   - une première unité (3) pour l'élévation durable du potentiel de générateur à une borne de sortie du générateur PV (2),
   - une deuxième unité (4) pour la détermination de la résistance d'isolation, étudiée pour, grâce à la mise en circuit d'une tension de mesure à la borne de sortie du générateur PV (2) et

   la mesure d'une première valeur de courant et d'une première valeur de tension avant la mise en circuit de la tension de mesure et
   la mesure d'une deuxième valeur de courant et d'une deuxième valeur de tension après la mise en circuit de la tension de mesure,
   déterminer la résistance d'isolation du générateur PV (2) en tenant compte des valeurs de courant et de tension mesurées,
   **caractérisé en ce que**

   - les première et deuxième unités (3, 4) sont connectées en série.

2. Dispositif selon la revendication 1, **caractérisé en ce que** les première et deuxième unités (3, 4) sont prévues en tant qu'appareils séparés.

3. Dispositif selon la revendication 1, **caractérisé en ce que** les première et deuxième unités (3, 4) sont intégrées dans un appareil.

4. Dispositif selon l'une des revendications précédentes, **caractérisé en ce que**
   la deuxième unité (4) est étudiée pour en outre mesurer une troisième valeur de courant et une troisième valeur de tension après la mise hors circuit de la tension de mesure et à en tenir compte lors de la détermination de la résistance d'isolation.

5. Dispositif selon la revendication 4, **caractérisé en ce que** la deuxième unité (4) est étudiée pour utiliser la troisième valeur de courant et la troisième valeur de tension en plus de l'évaluation d'une variation de paramètres influençant la détermination de résistance d'isolation pendant la durée globale des mesures.

6. Dispositif selon la revendication 3, **caractérisé en ce que** les première et deuxième unités (3, 4) sont intégrées dans un onduleur photovoltaïque (5) .

7. Installation photovoltaïque (20) comprenant un générateur PV (2), lequel est raccordé via des bornes (7, 8) à un onduleur photovoltaïque (5), dans laquelle un dispositif (1) pour la détermination de la résistance d'isolation selon l'une des revendications 1 à 6 est raccordé à l'une des bornes (7, 8) .

Fig. 1

Fig. 2

Fig. 3

EP 3 259 820 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0654673 B1
- DE 202006008936 U1
- DE 102011051954 A1
- DE 102011055220 A1